# EUROPEAN PATENT APPLICATION

(11) **EP 4 704 266 A1**
(43) Date of publication of application: **04.03.2026**
(21) Application number: 25171964.7
(22) Date of filing: 23.04.2025
(51) Int. Cl.: H01S 5/00, H01S 5/02257, H01S 5/042, H01S 5/40, H01S 5/024, H01S 5/183, H01S 5/42

(54) **LIGHT EMITTING CHIP, FULL COLOR LIGHT EMITTING STRUCTURE AND MANUFACTURING METHOD THEREOF**

(30) Priority: 29.08.2024 TW 113132544
(71) Applicant: Taiwan-Asia Semiconductor Corporation, Hsinchu City 30078 (TW)
(72) Inventor: LIN, Kun-Li, 30078 Hsinchu City (TW); CHEN, Chuan-Wei, 30078 Hsinchu City (TW); LIN, Jun-Ying, 30078 Hsinchu City (TW)
(74) Representative: Michalski Hüttermann & Partner Patentanwälte mbB

(57) **Abstract**

A light-emitting chip, a full-color light-emitting structure and manufacturing methods thereof are provided. The light-emitting chip includes a flip-chip epitaxial semiconductor structure and a frequency-doubling substrate. The flip-chip epitaxial semiconductor structure outputs a light, and the light has a wavelength. The frequency-doubling substrate is bonded to the flip-chip epitaxial semiconductor structure so that after the light passes through the frequency doubling substrate, the light is converted and the wavelength thereof is substantially reduced by one-half.

## Description

### BACKGROUND OF THE INVENTION

### Field of the Invention

The present invention relates to a light-emitting chip, a full-color light-emitting structure and a manufacturing method thereof, and in particular to a surface-emitting laser chip, a full-color surface-emitting laser structure and a manufacturing method thereof.

### Descriptions of the Related Art

In conventional laser projectors, a commonly used laser light source involves illuminating a phosphor color wheel with blue laser light to generate yellow light. A dichroic mirror then separates the yellow light into red and green components, producing the three primary colors-red, green, and blue-before mixing them for imaging. However, optical components such as the aforementioned color wheel and dichroic mirror have a certain volume, making them unsuitable for miniaturization requirements.

Currently, commercial VR (Virtual Reality) and AR (Augmented Reality) technologies employ several passive display technologies, including Liquid-Crystal Display (LCD), Liquid Crystal on Silicon (LCoS), Digital Light Processing (DLP), Micro Light-Emitting Diode Display (Micro LED Display), Micro Organic Light-Emitting Diode Display (Micro OLED), and Laser Beam Scanning (LBS). Among these, Micro LED, Micro OLED, and LBS have the advantage of miniaturized light sources, and related display technologies are undergoing rapid development. Specifically, the full-color LBS technology requires red, green, and blue (RGB) laser light sources. If an Edge-Emitting Laser (EEL) is used as the light source, while its technological development is relatively mature, the emitted laser beam has an elliptical shape, necessitating additional lenses to adjust its beam profile. Moreover, in practical applications, EELs often require additional reflective mirrors, making it difficult to achieve the requirements of a compact package.

On the other hand, a Vertical-Cavity Surface-Emitting Laser (VCSEL) is a type of surface-emitting laser, where the active region is oriented vertically within the chip, allowing the generated laser light to be emitted perpendicularly from the chip surface. Compared to edge-emitting lasers (EELs), VCSELs typically produce a circular beam with a small spot size and a uniform divergence angle, making them suitable for large-area uniform illumination. However, green VCSELs still face unresolved challenges, such as reliability issues and low optical efficiency. Therefore, providing a miniaturized laser light source for VR/AR devices remains a pressing issue.

### SUMMARY OF THE INVENTION

The main objective of the present invention is to provide an innovative light-emitting chip, a full-color light-emitting structure, and a method for manufacturing the same. This is achieved by growing a surface-emitting red laser with higher optical efficiency and reliability on a gallium arsenide (GaAs) substrate. Additionally, frequency-doubling technology, also known as Second Harmonic Generation (SHG), is employed to alter the laser wavelength, thereby developing stable blue and green laser chips. These chips serve as full-color laser light sources that meet the miniaturization requirements of VR/AR devices.

To achieve the above objective, the present invention discloses a light-emitting chip includes a flip-chip epitaxial semiconductor structure and a frequency-doubling substrate. The flip-chip epitaxial semiconductor structure outputs a light, and the light has a wavelength. The frequency-doubling substrate is bonded to the flip-chip epitaxial semiconductor structure so that after the light passes through the frequency doubling substrate, the light is converted and the wavelength thereof is substantially reduced by one-half.

In one embodiment of a light-emitting chip of the present invention, the wavelength outputted by the flip-chip epitaxial semiconductor structure is 600~1065 nanometers (nm).

In one embodiment of a light-emitting chip of the present invention, the material of the flip-chip epitaxial semiconductor structure is selected from one of the group consisting of indium gallium phosphide (InGaP), aluminum gallium indium phosphide (AlGaInP), gallium arsenide (GaAs), aluminum arsenide (AlAs), aluminum gallium arsenide (AlGaAs) and their combinations.

In one embodiment of a light-emitting chip of the present invention, the material of the frequency-doubling substrate is selected from one of the group consisting of neodymium doped yttrium aluminum tetraborate (NYAB), ytterbium doped yttrium aluminum tetraborate (Yb:YAB), neodymium or ytterbium doped calcium oxyborate (Nd/Yb:RECOB), and their combinations.

In one embodiment of a light-emitting chip of the present invention, the light-emitting chip further comprises a suppression layer disposed on the frequency-doubling substrate to suppress the part of the light exceeding a specific wavelength from passing through the suppression layer after passing through the frequency-doubling substrate.

In one embodiment of a light-emitting chip of the present invention, the flip-chip epitaxial semiconductor structure is a flip-chip surface-emitting laser chip.

To achieve the above objective, the present invention discloses a full-color light-emitting structure which comprises a substrate, a first light-emitting chip, a second light-emitting chip and a third light-emitting chip. The first light-emitting chip is disposed on the substrate and configured to emit a first light with a wavelength of 620~750 nanometers (nm). The second light-emitting chip is disposed on the substrate and configured to emit a second light with a wavelength of 450~495 nanometers (nm). The third light-emitting chip is disposed on the substrate and configured to emit a third light with a wavelength of 495~570 nanometers (nm).

In one embodiment of a full-color light-emitting structure of the present invention, the first light-emitting chip is a surface-emitting laser chip.

In one embodiment of a full-color light-emitting structure of the present invention, the first light-emitting chip is a flip-chip surface-emitting laser chip.

In one embodiment of a full-color light-emitting structure of the present invention, the second light-emitting chip and the third light-emitting chip are flip-chip surface-emitting laser chips.

In one embodiment of a full-color light-emitting structure of the present invention, the material of the flip-chip epitaxial semiconductor structure is selected from one of the group consisting of indium gallium phosphide (InGaP), aluminum gallium indium phosphide (AlGaInP), gallium arsenide (GaAs), aluminum arsenide (AlAs), aluminum gallium arsenide (AlGaAs) and their combinations.

In one embodiment of a full-color light-emitting structure of the present invention, the material of the frequency-doubling substrate is selected from one of the group consisting of neodymium doped yttrium aluminum tetraborate (NYAB), ytterbium doped yttrium aluminum tetraborate (Yb:YAB), neodymium or ytterbium doped calcium oxyborate (Nd/Yb:RECOB), and their combinations.

In one embodiment of a full-color light-emitting structure of the present invention, the full-color light-emitting structure further comprises a cover having three light-emitting windows, corresponding to the first light-emitting chip, the second light-emitting chip and the third light-emitting chip, so that the first light, the second light and the third light can be respectively emitted to the outside after passing through each of the light-emitting windows.

In one embodiment of a full-color light-emitting structure of the present invention, the full-color light-emitting structure further comprises a first suppression layer disposed on the light-emitting windows to suppress the portion of the second light and the third light exceeding a specific wavelength from passing through the first suppression layer after passing through the light-emitting windows.

In one embodiment of a full-color light-emitting structure of the present invention, the full-color light-emitting structure further comprises a second suppression layer and a third suppression layer respectively disposed on the second light-emitting chip and the third light-emitting chip to respectively suppress the portion of the second light and the third light exceeding a specific wavelength from passing through the second suppression layer and the third suppression layer.

To achieve the above objective, the present invention discloses a manufacturing method of a light-emitting chip comprising the following steps: providing a flip-chip epitaxial semiconductor structure configured to output a light with a wavelength; and providing a frequency-doubling substrate configured to be attached to the flip-chip epitaxial semiconductor structure, wherein, after the light passes through the frequency- doubling substrate, the light is converted to substantially reduce the wavelength thereof by one-half.

In one embodiment of a manufacturing method of a light-emitting chip of the present invention, the step of providing a flip-chip epitaxial semiconductor structure is to provide an epitaxial composite layer on an epitaxial growth substrate.

In one embodiment of a manufacturing method of a light-emitting chip of the present invention, the method further comprises a step of removing the epitaxial growth substrate after the frequency-doubling substrate is bonded to the flip-chip epitaxial semiconductor structure.

In one embodiment of a manufacturing method of a light-emitting chip of the present invention, the method further comprises a step of providing a suppression layer disposed on the frequency-doubling substrate to suppress the part of the light exceeding a specific wavelength from passing through the suppression layer after passing through the frequency-doubling substrate.

To achieve the above objective, the present invention discloses a manufacturing method of a full-color light-emitting structure which comprises the following steps: providing a first light-emitting chip disposed on a substrate and configured to emit a first light with a wavelength of 620~750 nanometers (nm); providing a second light-emitting chip disposed on the substrate and configured to emit a second light with a wavelength of 450~495 nanometers (nm); and providing a third light-emitting chip disposed on the substrate and configured to emit a third light with a wavelength of 495~570 nanometers (nm).

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1(A) to FIG. 1(J) are schematic diagrams illustrating the manufacturing process of a light-emitting chip in one embodiment of the present invention.
FIG. 2 is a schematic diagram of a full-color light-emitting structure in one embodiment of the present invention.
FIG. 3 is a schematic diagram of a full-color light-emitting structure in another embodiment of the present invention.
FIG. 4 is a schematic diagram illustrating the process steps for manufacturing the light-emitting chip of the present invention.
FIG. 5 is a schematic diagram illustrating the process steps for manufacturing the full-color light-emitting structure of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

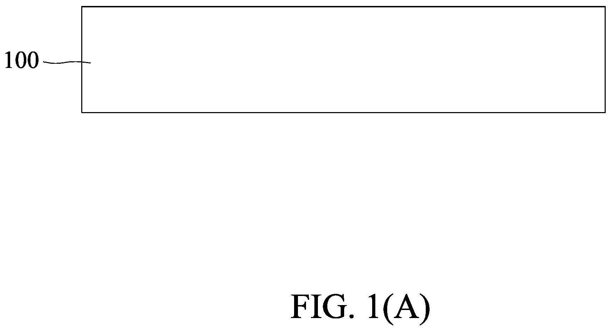

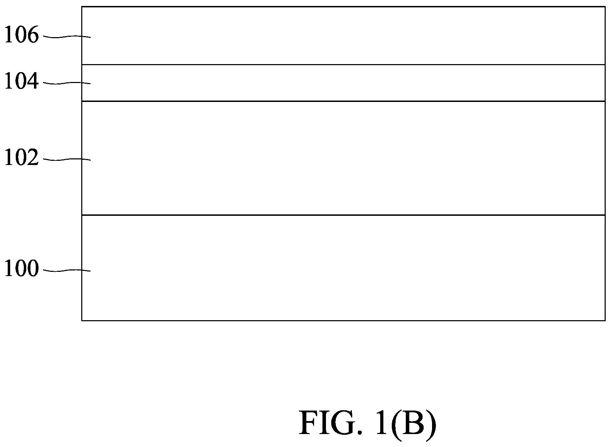

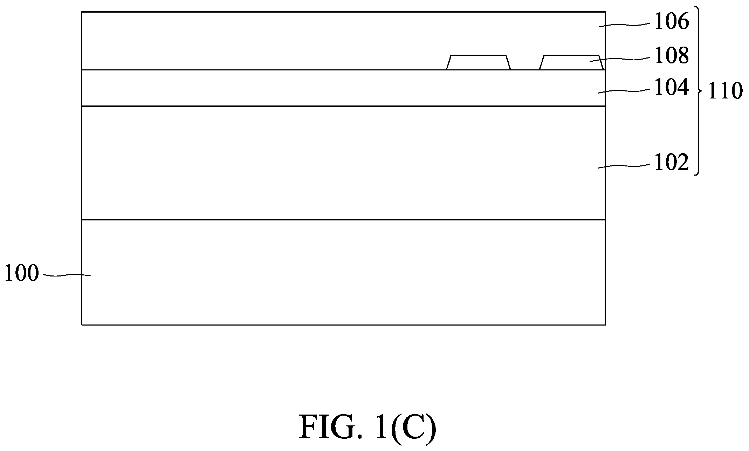

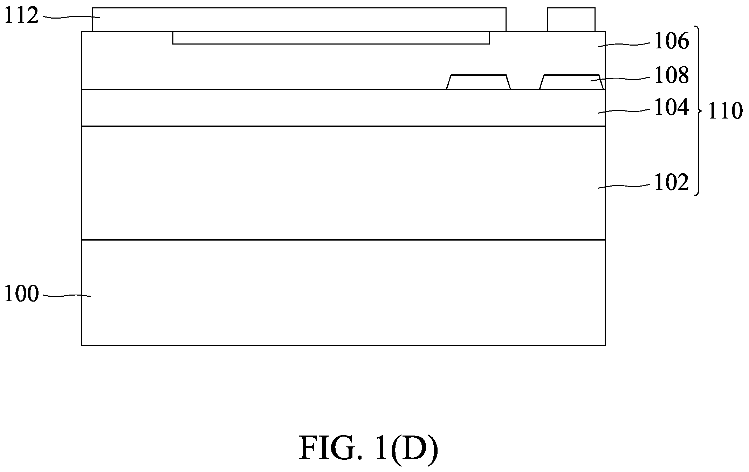

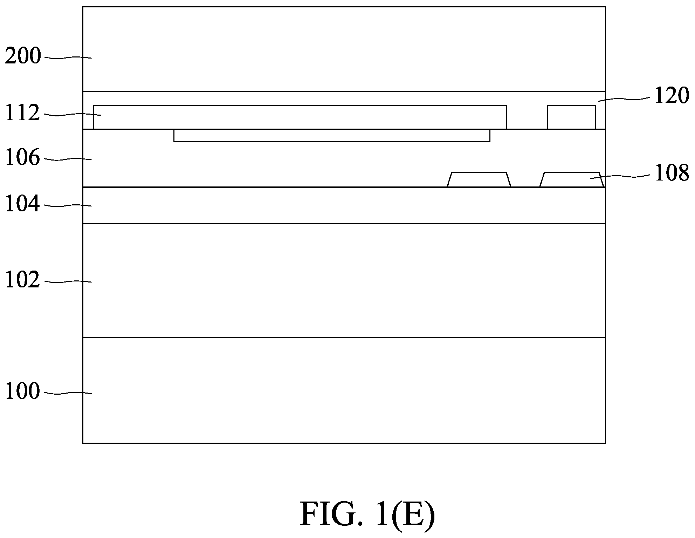

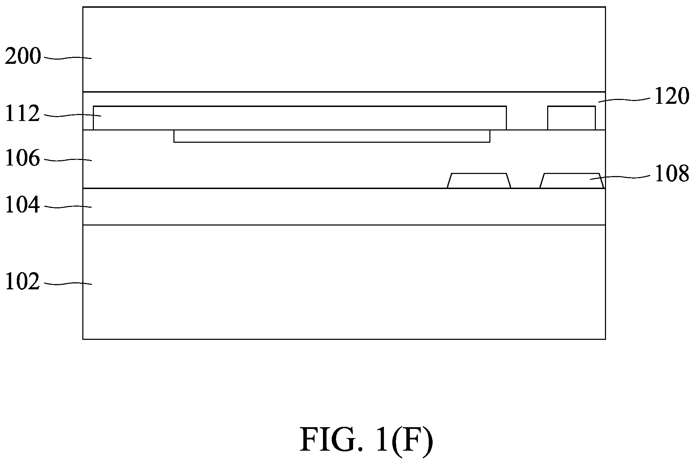

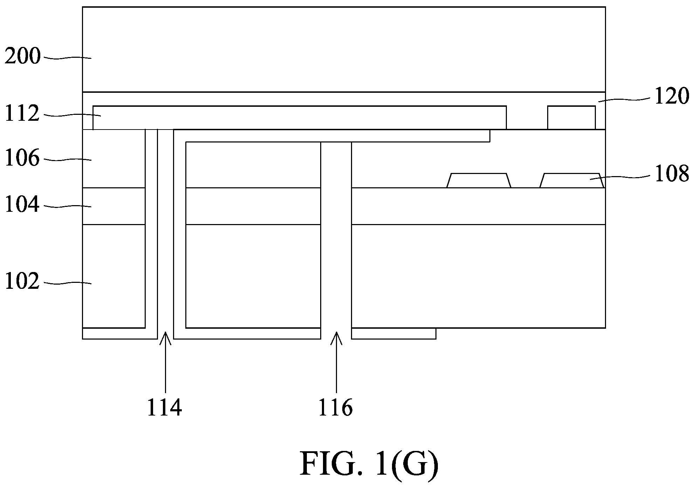

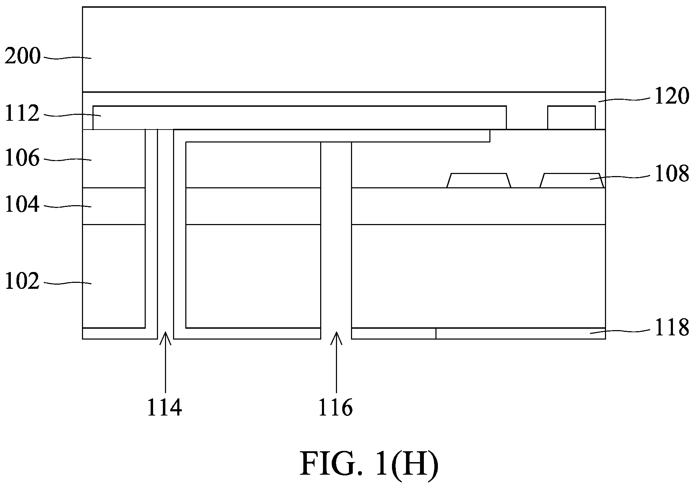

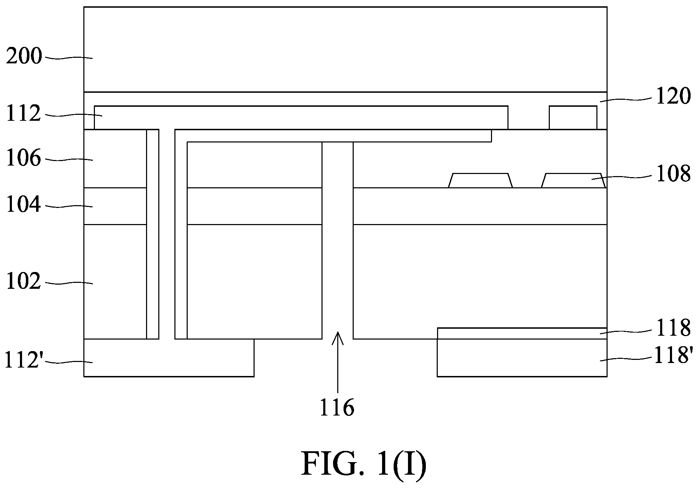

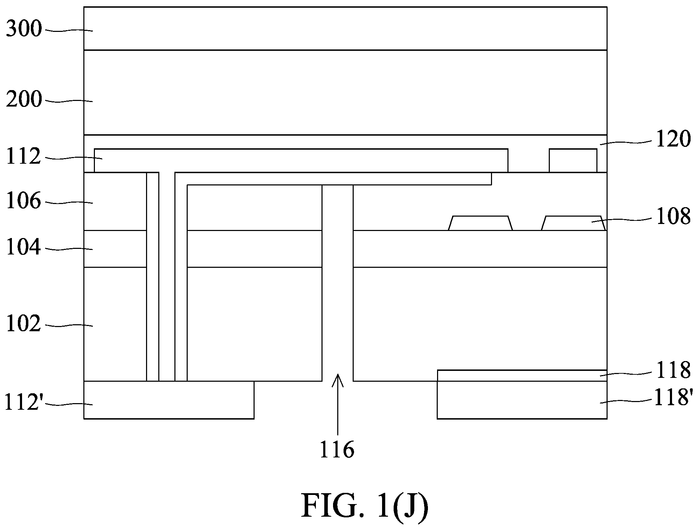

The present invention discloses a light-emitting chip and a full-color light-emitting structure that applies the light-emitting chip. More specifically, the light-emitting chip disclosed in the present invention is related to a Vertical Cavity Surface Emitting Laser (VCSEL) chip. The method for manufacturing the light-emitting chip in this invention is described in detail below. As shown in FIG. 1, in an embodiment of the present invention, a first step is to provide an epitaxial growth substrate 100. This epitaxial growth substrate 100 can be, for example, but not limited to, a gallium arsenide (GaAs) epitaxial growth substrate. The characteristic of using a GaAs epitaxial growth substrate for a laser light-emitting chip is that it allows for the growth of lattice-matched and conductive materials from the aluminum gallium arsenide (AlₓGa_{y}As) system, which serves as the Distributed Bragg Reflection (DBR) mirror for the VCSEL. The GaAs material can be used for light emission in the wavelength range of about 600~1065 nm, providing full-color laser light sources, including the red light required from the RGB primary colors. The other two color lights, blue and green, are generated by frequency-doubling the red light, thus providing a complete RGB light source, as will be further described.

Referring to FIG. 1(B), the epitaxial growth substrate 100 undergoes epitaxial growth using techniques such as Metal Organic Chemical Vapor Deposition (MOCVD) or Molecular Beam Epitaxy (MBE) to form an epitaxial composite layer 110. This epitaxial composite layer 110 consists of an N-type epitaxial DBR layer 102, a Multiple Quantum Well (MQW) layer 104, and a P-type epitaxial DBR layer 106 sequentially formed on the epitaxial growth substrate 100. The epitaxial materials for each layer may vary depending on the desired emission wavelength (for example, 650 nm, 940 nm, 1065 nm). Specifically, materials that are lattice-matched to GaAs, such as those selected from one of the group consisting of InGaP, AlGaInP, GaAs, AlAs, or AlGaAs and their combinations, can be suitably adjusted as epitaxial growth materials.

Referring to FIG. 1(C), a current-blocking layer 108 is formed in the epitaxial composite layer 110 using methods such as wet oxidation or ion implantation. For example, areas with higher aluminum content are oxidized to form aluminum oxide (Al₂O₃), blocking lateral current flow and allowing current to flow only in the vertical direction. By precisely controlling the position and thickness of the oxide layer, the current path can be controlled. Then, as shown in FIG. 1(D), the P-type contact electrode 112 is formed, which includes an insulating process between the electrode and the epitaxial composite layer, as well as a patterning design for the current-blocking layer 108 to ensure that the laser light can be efficiently emitted.

Referring to FIG. 1(E), a frequency-doubling substrate 200 is then provided to bond to the epitaxial composite layer 110 for laser frequency doubling conversion. When the laser light passes through the frequency-doubling substrate 200, the material in the substrate excites electrons and induces vibrations. The frequency of these vibrations is twice that of the original input laser light, and thereby, effectively doubles the frequency and halve the wavelength. The frequency-doubling substrate can be selected from materials such as, but not limited to, neodymium doped yttrium aluminum tetraborate (NYAB), ytterbium doped yttrium aluminum tetraborate (Yb:YAB), neodymium or ytterbium doped calcium oxyborate (Nd/Yb:RECOB), and their combinations. Any material that can be made into wafer form and efficiently converts light can serve as the frequency-doubling substrate. In a specific implementation of the present invention, the epitaxial composite layer 110 to emit near-infrared laser with a wavelength of 1065 nanometers (nm), which is relatively mature in efficiency and reliability, can be selected to be matched with an appropriate frequency-doubling substrate 200 for converting the near-infrared laser into a green laser with a wavelength of 532 nanometers (nm). Alternatively, the epitaxial composite layer 110 that emits an infrared laser of 940 nanometers (nm) is selected to be matched with an appropriate frequency-doubling substrate 200 to convert the infrared laser into a blue laser with a wavelength of 470 nanometers (nm).

Next, as shown in FIG. 1(E), during the wafer bonding process between the epitaxial composite layer 110 and the frequency-doubling substrate 200, a transparent bonding material 120, such as epoxy resins or dielectric layers such as SiO₂ or Al₂O₃, is used to bond the frequency-doubling substrate 200 to the epitaxial composite layer 110. This allows the laser light emitted from the epitaxial composite layer 110 to pass through the frequency-doubling substrate and have its wavelength reduced to one-half. Subsequently, as shown in FIG. 1(F), the epitaxial growth substrate 100 is removed after the bonding process.

Referring to FIG. 1(G), several drilling and related insulating processes are performed to form a through hole 114 for the P-type contact electrode, and a trench 116 for isolating the P-type and N-type sides. Then, as shown in FIG. 1(H), an N-type contact electrode 118 is formed. Next, as shown in FIG. 1(I), electrode connection steps for the flip-chip epitaxial semiconductor structure are performed. Specifically, metal plating is used to fill the through hole 114 with P-type contact metal and connect the P-type contact electrode 112 to the P-type contact electrode pad 112'. Similarly, an N-type contact electrode pad 118' is formed on the N-type contact electrode 118 and electrically connects thereto. This flip-chip structure ensures that the laser chip can efficiently dissipate heat through the electrode pads, thus enhancing laser chip performance.

In a real embodiment, the VCSEL will not achieve 100% conversion efficiency for frequency-doubling. To block unconverted light, a suppression layer 300 is added on the light-emitting surface of the frequency-doubling substrate 200 for suppressing the light exceeding a specific wavelength, as shown in FIG. 1(J). Thus, the light originally produced by the epitaxial composite layer in the infrared spectrum will be suppressed from passing through the suppression layer. Specifically, this suppression layer 300 includes high and low refractive index materials such as SiO₂ and TiO₂, stacked alternately as an optical coating layer. These coatings can be adjusted in thickness and refractive index to control the wavelength ranges for being reflected or transmitted. For example, in a blue VCSEL chip, the suppression layer 300 can block infrared light with wavelengths longer than 940 nm, and in a green VCSEL chip, it can block near-infrared light with wavelengths longer than 1065 nm.

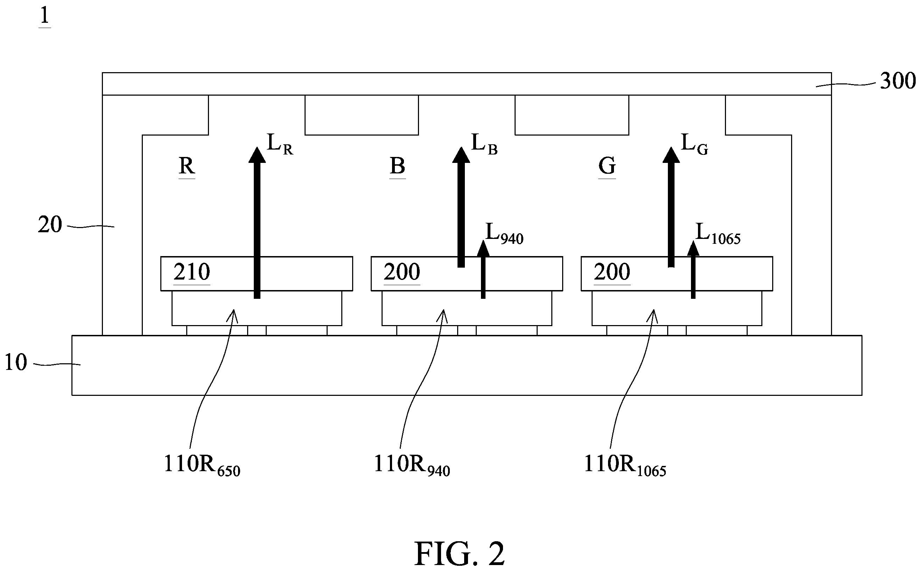

The above disclosure relates to light-emitting chips for red, blue, and green lasers. Next, the following describes a full-color light-emitting structure based on these three primary colors, specifically the full-color VCSEL light-emitting structure. As shown in FIG. 2, the full-color light-emitting structure 1 of an embodiment of the invention includes a substrate 10, a cover 20, and a first light-emitting chip R, a second light-emitting chip B, and a third light-emitting chips G. These three R, B, and G chips are configured to be disposed adjacently on the substrate 10 and electrically connected to the substrate.

Specifically, the first light-emitting chip R is a red surface-emitting laser chip or a red flip-chip surface-emitting laser chip. This first light-emitting chip R has an epitaxial composite layer 110R₆₅₀ that emits red laser light (L_{R}) with a wavelength between 620 and 750 nm, and the epitaxial composite layer 110R₆₅₀ matched with a substrate 210 acts as a supporter. The substrate 210 is a sapphire, for example. Moreover, the second light-emitting chip B is a blue flip-chip surface-emitting laser chip, using the frequency-doubling technique described above for blue light. This second light-emitting chip B has an epitaxial composite layer 110R₉₄₀ that emits infrared light L₉₄₀ with a wavelength between 900 and 990 nm, which, after frequency doubling by the frequency-doubling substrate 200, is converted to blue laser light L_{B} with a wavelength between 450 and 495 nm. On the other hand, the third light-emitting chip G is a green flip-chip surface-emitting laser chip, using the same frequency-doubling technique. This green flip-chip surface-emitting laser chip G emits near-infrared laser light L₁₀₆₅ with a wavelength between 990 and 1140 nm, which, after frequency doubling by the frequency-doubling substrate 200, is converted to green laser light L_{G} with a wavelength between 495 and 570 nm.

Further referring to FIG. 2, the full-color light-emitting structure 1 also includes a cover 20. This cover 20 has three light-emitting windows, each corresponding to the first, second, and third light-emitting chips R, B, and G, allowing the first light (i.e., red laser light L_{R}), the second light (i.e., blue laser light L_{B}), and the third light (i.e., green laser light L_{G}) emitted by the respective chips to individually pass through each window and be emitted to the outside. In a preferred embodiment, to precisely control the mixing of the color lights and prevent the portion of the light that has not been frequency-doubled and converted by the frequency-doubling substrate from spilling out, a suppression layer 300 can be added to each light-emitting window of the cover 20 to limit the second light and the third light with wavelengths exceeding a specific value from passing through the suppression layer 300 after passing through each window. For example, the suppression layer 300 suppresses the light with wavelengths exceeding 940 nm from passing through for ensuring the full-color control effect of three colors light-emitting chips.

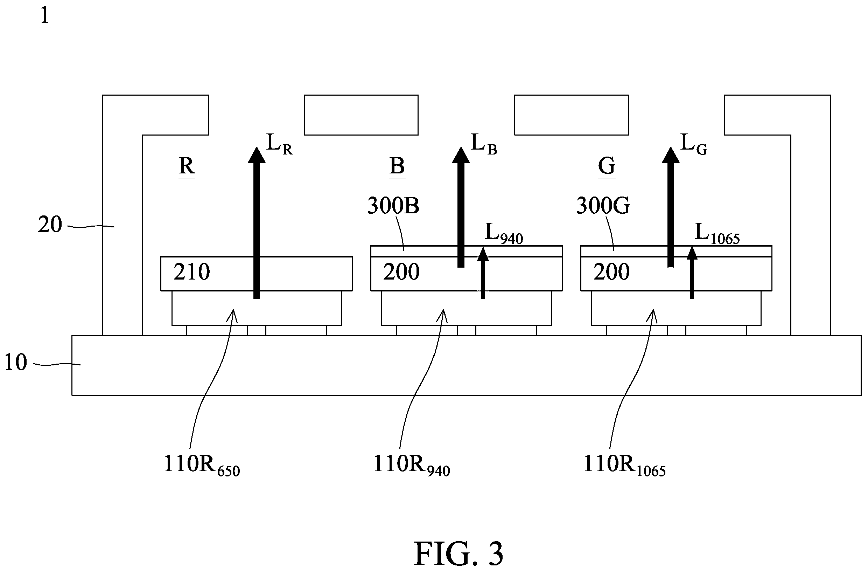

Please refer to FIG. 3, which shows a schematic diagram of the full-color light-emitting structure 1 in another embodiment of the present invention. The embodiment shown in FIG. 3 differs from that shown in FIG. 2 in that, in the full-color light-emitting structure 1 of FIG. 3, the suppression layer 300 is not disposed on the light-emitting window of the cover 20, but instead, as shown in FIG. 1(J), the suppression layer 300 is disposed on each of the individual light-emitting chips. The rest parts of the two embodiments are the same. Specifically, the full-color light-emitting structure 1 shown in FIG. 3 further includes a second suppression layer 300B and a third suppression layer 300G, which are respectively disposed on the second light-emitting chip B and the third light-emitting chip G to suppress the portion of light with wavelengths exceeding a specific value in the second and third light rays from passing through the second suppression layer 300B or the third suppression layer 300G. In other words, when the frequency-doubling substrate 200 of the second light-emitting chip B does not fully frequency-double the infrared laser L₉₄₀, the second light ray will contain residual infrared laser L₉₄₀ and will be suppressed by the second suppression layer 300B and prevented from passing through. As a result, only the blue laser L_{B}, with a wavelength range of 450~495 nanometers (nm), can pass therethrough. Similarly, when the frequency-doubling substrate 200 of the third light-emitting chip G does not fully frequency-double the near-infrared laser L₁₀₆₅, the third light ray will contain residual near-infrared laser L₁₀₆₅ and will be suppressed by the third suppression layer 300G and prevented from passing therethrough. As a result, only the green laser L_{G}, with a wavelength range of 495~570 nanometers (nm), can pass therethrough. This arrangement allows for precise control of the output of each color light, thereby improving image quality.

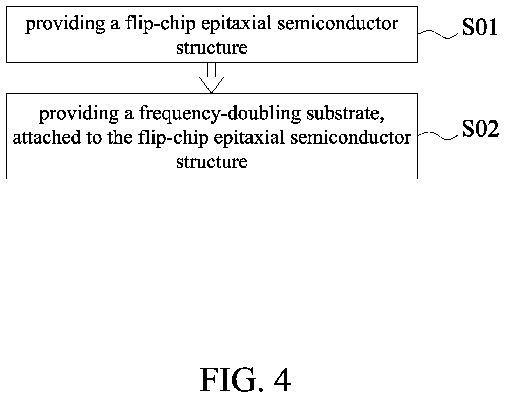

Referring to FIG. 4, the process steps for manufacturing the light-emitting chip of the present invention are shown. First, in step S01, a flip-chip epitaxial semiconductor structure is provided. The flip-chip epitaxial semiconductor structure can output a light, and the light has a wavelength. Secondly, in step S02, a frequency doubling substrate is provided and attached to the flip-chip epitaxial semiconductor structure, so that after the light generated by the flip-chip epitaxial semiconductor structure passes through the frequency doubling substrate, the light is converted to substantially reduce the wavelength of the light by one-half.

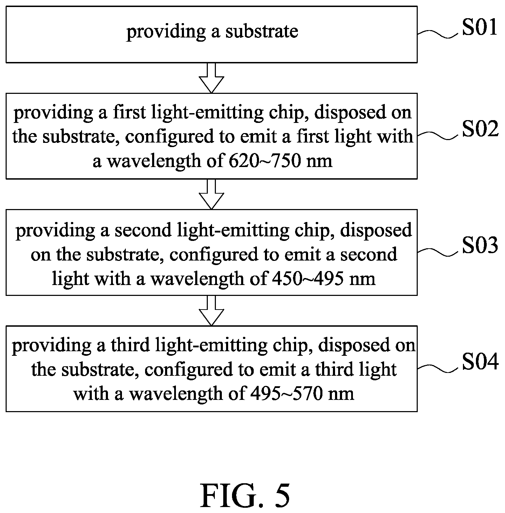

Please refer to Figure 5, which shows a schematic diagram of the process steps for the full-color light-emitting structure of the present invention. First, in step S01, a substrate is provided. Next, in step S02, a first light-emitting chip is provided, disposed on the substrate, and used to emit a first light with a first wavelength. In step S03, a second light-emitting chip is provided, disposed on the substrate, and used to emit a second light with a second wavelength. In step S04, a third light-emitting chip is provided, disposed on the substrate, and used to emit a third light with a third wavelength. The aforementioned first wavelength is in the range of 620 to 750 nanometers (nm), the second wavelength is in the range of 450 to 495 nanometers (nm), and the third wavelength is in the range of 495 to 570 nanometers (nm). The functions and components of the elements in FIG. 4 and FIG. 5 can be referred to from the previous technical content and will not be reiterated here.

In summary, this invention forms a surface-emitting laser epitaxial layer on a gallium arsenide epitaxial growth substrate, transfers the epitaxial composite layer to the frequency doubling substrate through wafer bonding technology, and then undergoes semiconductor processes, such as, photolithography, chemistry, evaporation, fusion, or the like, to produce a vertical resonant cavity surface-emitting laser chip with a flip-chip semiconductor structure. The surface-emitting laser light passes through the frequency doubling crystal, and the wavelength of the laser light is essentially reduced to half. Using this technique, a 1065 nm near-infrared laser is frequency-doubled to a 532 nm green laser, and a 940 nm infrared laser is frequency-doubled to a 470 nm blue laser. Additionally, a 650 nm red laser directly grown on a gallium arsenide substrate can be used, forming a full-color VCSEL light-emitting structure. Specifically, this full-color light-emitting structure is composed of red, blue, and green light-emitting chips, which are efficient and reliable, and do not require additional optical systems such as color wheels or beam-splitting prisms. Therefore, the light-emitting chips and full-color light-emitting structure of the present invention can meet the miniaturization requirements for full-color laser light sources in VR and AR devices.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A light-emitting chip, comprising:
a flip-chip epitaxial semiconductor structure, configured to output a light with a wavelength; and
a frequency-doubling substrate, configured to be attached to the flip-chip epitaxial semiconductor structure,
wherein, after the light passes through the frequency-doubling substrate, the light is converted to substantially reduce the wavelength thereof by half.

2. The light-emitting chip of the previous claim, wherein the wavelength outputted by the flip-chip epitaxial semiconductor structure is 600~1065 nanometers (nm).

3. The light-emitting chip of any of the previous claims, wherein the material of the flip-chip epitaxial semiconductor structure is selected from one of the group consisting of indium gallium phosphide (InGaP), aluminum gallium indium phosphide (AlGaInP), gallium arsenide (GaAs), aluminum arsenide (AlAs), aluminum gallium arsenide (AlGaAs) and their combinations, or wherein the material of the frequency-doubling substrate is selected from one of the group consisting of neodymium doped yttrium aluminum tetraborate (NYAB), ytterbium doped yttrium aluminum tetraborate (Yb:YAB), neodymium or ytterbium doped calcium oxyborate (Nd/Yb:RECOB), and their combinations.

4. The light-emitting chip of any of the previous claims, further comprising a suppression layer disposed on the frequency-doubling substrate to suppress the part of the light exceeding a specific wavelength from passing through the suppression layer after passing through the frequency-doubling substrate.

5. The light-emitting chip of any of the previous claims, wherein the flip-chip epitaxial semiconductor structure is a flip-chip surface-emitting laser chip.

6. A full-color light-emitting structure, comprising:
a substrate;
a first light-emitting chip, disposed on the substrate, configured to emit a first light with a wavelength of 620~750 nanometers (nm);
a second light-emitting chip, as claimed in any of the previous claims 1 to 5, disposed on the substrate, configured to emit a second light with a wavelength of 450~495 nanometers (nm); and
a third light-emitting chip, as claimed in any of the previous claims 1 to 5, disposed on the substrate, configured to emit a third light with a wavelength of 495~570 nanometers (nm).

7. The full-color light-emitting structure of the previous claim, wherein the first light-emitting chip is a surface-emitting laser chip, wherein preferably the first light-emitting chip is a flip-chip surface-emitting laser chip.

8. The full-color light-emitting structure of any of the previous two claims, wherein the second light-emitting chip and the third light-emitting chip are flip-chip surface-emitting laser chips.

9. The full-color light-emitting structure of any of the previous three claims, wherein the material of the flip-chip epitaxial semiconductor structure is selected from one of the group consisting of indium gallium phosphide (InGaP), aluminum gallium indium phosphide (AlGaInP), gallium arsenide (GaAs), aluminum arsenide (AlAs), aluminum gallium arsenide (AlGaAs) and their combinations, or wherein the material of the frequency-doubling substrate is selected from one of the group consisting of neodymium doped yttrium aluminum tetraborate (NYAB), ytterbium doped yttrium aluminum tetraborate (Yb:YAB), neodymium or ytterbium doped calcium oxyborate (Nd/Yb:RECOB), and their combinations.

10. The full-color light-emitting structure of any of the previous four claims, further comprising a cover having three light-emitting windows, corresponding to the first light-emitting chip, the second light-emitting chip and the third light-emitting chip, so that the first light, the second light and the third light can be respectively emitted to the outside after passing through each of the light-emitting windows, preferably further comprising a first suppression layer disposed on the light-emitting windows to suppress the portion of the second light and the third light exceeding a specific wavelength from passing through the first suppression layer after passing through the light-emitting windows.

11. The full-color light-emitting structure of any of the previous five claims, further comprising a second suppression layer and a third suppression layer respectively disposed on the second light-emitting chip and the third light-emitting chip to respectively suppress the portion of the second light and the third light exceeding a specific wavelength from passing through the second suppression layer and the third suppression layer.

12. A manufacturing method of a light-emitting chip, comprising:
providing a flip-chip epitaxial semiconductor structure, configured to output a light with a wavelength; and
providing a frequency-doubling substrate, configured to be attached to the flip-chip epitaxial semiconductor structure,
wherein, after the light passes through the frequency-doubling substrate, the light is converted to substantially reduce the wavelength thereof by one-half.

13. The manufacturing method of a light-emitting chip of the previous claim, wherein the step of providing a flip-chip epitaxial semiconductor structure is to provide an epitaxial composite layer on an epitaxial growth substrate, preferably further comprising a step of removing the epitaxial growth substrate after the frequency-doubling substrate is bonded to the flip-chip epitaxial semiconductor structure.

14. The manufacturing method of a light-emitting chip of any of the previous two claims, further comprising a step of providing a suppression layer disposed on the frequency-doubling substrate to suppress the part of the light exceeding a specific wavelength from passing through the suppression layer after passing through the frequency-doubling substrate.

15. A manufacturing method of a full-color light-emitting structure, comprising:
providing a first light-emitting chip, disposed on a substrate, configured to emit a first light with a wavelength of 620~750 nanometers (nm);
providing a second light-emitting chip, as claimed in any of the previous claims 1 to 5, disposed on the substrate, configured to emit a second light with a wavelength of 450~495 nanometers (nm); and
providing a third light-emitting chip, as claimed in any of the previous claims 1 to 5, disposed on the substrate, configured to emit a third light with a wavelength of 495~570 nanometers (nm).
